# EUROPEAN PATENT SPECIFICATION

(11) **EP 3 326 986 B1**
(45) Date of publication and mention of the grant of the patent: **25.11.2020**
(21) Application number: 16200876.7
(22) Date of filing: 28.11.2016
(51) Int. Cl.: C04B 37/02, H01L 21/48, H01L 23/373, C04B 37/00, C04B 35/645, B32B 15/00, B32B 18/00, B33Y 10/00, H01L 23/15

(54) **PROCESS FOR THE MANUFACTURE OF A METAL-CERAMIC SUBSTRATE**
VERFAHREN ZUR HERSTELLUNG EINES METALL-KERAMIK-SUBSTRATS
PROCÉDÉ DE FABRICATION D'UN SUBSTRAT EN CÉRAMIQUE-MÉTAL

(43) Date of publication of application: 30.05.2018
(73) Proprietor: Infineon Technologies AG, 85579 Neubiberg (DE)
(72) Inventor: ROTH, Alexander, 93197 Zeitlarn (DE)
(74) Representative: Dilg, Haeusler, Schindelmann Patentanwaltsgesellschaft mbH

(56) References cited:
- EP-A2- 0 788 153
- DE-A1-102014 203 309
- US-A1- 2012 107 642
- US-A1- 2016 304 405
- Heiko Thust ET AL: "ADVANCED LTCC PROCESSES USING PRESSURE ASSISTED SINTERING", , 10 February 2004 (2004-02-10), XP055375158, Retrieved from the Internet: URL:http://www.imaps.org/ceramics/Denver-T HUST.pdf [retrieved on 2017-05-23]

## Description

The present invention relates to a process for the manufacture of a metal-ceramic substrate.

Metal-ceramic substrates are preferably used in the field of power semiconductor modules. In this case, a ceramic plate or a ceramic layer, for example an alumina ceramics, is provided with metallization on at least one on its surface sides, for example the top side and/or bottom side, wherein in at least one metallized side a circuitry structure for example created by etching processes is incorporated, such as for example conductor lines, contact areas and/or terminal areas. Such ceramic substrates having metallization thereon are for example employed as interconnect devices of power electronic modules, in which they assure thermal and mechanical connection as well as electrical insulation.

Application of metallization on a ceramic substrate may be done by a method, such as for example described in DE 23 19 854 A. Herein, a metal part, for example a copper plate or copper foil, is provided on the surface sides with a coating from a chemical compound of that metal and a reactive gas, especially oxygen. This coating, together with a thin layer of the adjacent metal, forms an eutectic of a melting temperature below the melting temperature of the metal. The metal part is subsequently superimposed on the ceramic substrate and together with the ceramics is heated to a temperature above the melting point of the eutectic and below the melting temperature of the metal. In doing so, substantially only the eutectic interlayer will be melted on. After cooling down, the metal part and the ceramic substrate are bonded together. If using copper alloy as a metal, this process is also referred to as DCB bonding or DCB process (DCB: Direct Copper Bonding), albeit it is also allowed to be performed with other metals. For example, the DCB process comprises the following process steps:
- oxidizing a copper foil, such that a uniform copper oxide layer will be formed;
- superimposing the copper foil on the ceramic layer;
- heating the composite to a process temperature of between approximately 1025 °C and 1083 °C, e.g. appx. 1071 °C; and
- cooling to room temperature.

The composite material thereby obtained, i.e. the metal-ceramic substrate, may then be further processed in the desired manner.

A process known for the manufacture of a thickness metallization on a ceramic substrate is the so called active solder process (AMB: Active Metal Brazing), such as it is for example employed in DE 22 13 115 A or EP 153 618 A2. In this process, connection is created between a metal foil and a ceramic substrate at a temperature between appx. 800 and 1200 °C using hard solder, which, in addition to a main component such as copper, silver and/or gold, also contains an active metal. That active metal, for example at least one element selected from the group consisting of Hf, Ti, Zr, Nb or Ce, creates connection by way of chemical reaction between the solder and the ceramics, whereas connection between the solder and the metal is formed by a hard soldering metal connection.

Furthermore, EP 1 403 229 B1 describes a process for the manufacture of an aluminum-ceramic composite substrate, wherein, instead of copper, an aluminum plate is attached to at least one surface side of an alumina or aluminum nitride ceramics.

In some power semiconductor modules it is of great advantage if they have little inductance. This, among others, may be achieved in that the metal-ceramic substrate is provided with several current-carrying superimposed metallizing layers isolated from each other, carrying almost antiparallel currents.

From DE 10 2010 049 499 A1, for example, a multilayer metal-ceramic substrate is known, which comprises two ceramic layers, which are connected through bonding via an inner metal layer. Metallizations are also provided at the respective outer surface sides of the two ceramic layers. The metallizations are attached to the already manufactured ceramic layers, for example by bonding.

Moreover, in the article "Advanced LTCC Processes Using Pressure Assisted Sintering (PAS)", SMTA Pan Pacific Conference, Hawaii, USA, 2004, of H. Thust et al. a process for the manufacture of multilayer circuits in connection with glass ceramics (LTCC: Low temperature Cofired Ceramics) as interconnect devices is described. Herein, metal parts are inserted into the glass ceramics, and the metal-glass ceramic-composite is sintered by the use of pressure, to desirably affect the shrinking behavior. Glass ceramics have the advantage that their sintering temperature is below the melting temperature of the metal inserts.

EP 0 788 153 A2 discloses a method of manufacturing a member for a semiconductor device, in which a conductor layer consisting of copper is bonded to ceramic substrate material. The manufacture of an electronic module wherein an additive 3D-printing method is used to apply an electrically conductive structuring on an electronic component is disclosed in DE 10 2014 203 309 A1. US 2016/0304405 A1 discloses a method for producing a metal-ceramic substrate comprising first and second metallizations and at least one ceramic layer accommodated between both metallizations. A method for manufacturing a metal-ceramic substrate wherein a metal layer is DCB-bonded to a ceramic layer is disclosed in US 2012/0107642 A1.

In the light of this context, the present invention aims at providing a process for the manufacture of a metal-ceramic substrate, which is improved especially in the view of savings in process cost. Furthermore, the process is intended enable the manufacture of multilayer metal-ceramic substrates, which besides optional metallization on one or both of their outer surfaces, may also comprise metallization in their interior (herein also referred to as metallization buried in the ceramic substrate or inner metallization).

This object will be solved by the characteristics of claim 1. Other, especially advantageous embodiments of the invention will be apparent from the subclaims. It is to be noted that, in the following description, characteristics individually set forth may be combined in any technical reasonable way and will reveal further embodiments of the invention. In addition, the description characterizes and specifies the invention especially in combination with the figures.

According to the invention a process for the manufacture of a metal-ceramic substrate comprises at least the steps of:
- initially forming a metal-ceramic assembly of ceramic material at least partially non-sintered and at least one oxidized metal body that at least partially is in contact with the ceramic material;
- subsequently sintering the ceramic material of the metal-ceramic assembly at a sintering temperature below a bonding temperature of the metal body and at a sintering pressure higher than atmospheric air pressure for a predictable sintering period to form a ceramic body from the ceramic material in the presence of the metal body, wherein:
   ∘ the ceramic material to be sintered is a ceramic material, which, under atmospheric air pressure, sinters at a temperature above the bonding temperature of the metal body,
   ∘ the sintering temperature is between 500 °C and 900 °C, and
   ∘ the sintering pressure is between 1 GPa to 8 GPa;
- finally, DCB bonding the metal body of the metal-ceramic assembly to the sintered ceramic body at a bonding temperature between 1025 °C and 1083 °C for a predictable bonding period to form the metal-ceramic substrate; and
- cooling the metal-ceramic substrate to room temperature.

"Bonding" in the sense of the invention generally means connecting, specifically DCB bonding. Such connection methods for connecting a metal body to a ceramic body have already been explained herein in the introductory part.

As ceramic materials in the process according to the invention especially technical ceramic materials may be used such as for example Al₂O₃ (alumina), AIN (aluminum nitride), Si₃N₄ (silicium nitride) and the like, all featuring a sintering temperature, at which the ceramic material fuses into a uniform ceramic body, the sintering temperature without applying super-atmospheric air pressure during sintering being higher than the bonding temperature of approximately between 1025°C and 1083°C, for example 1065°C, at which temperature the metal body connects with the ceramic body.

However, applying pressure according to the invention during sintering of the ceramic body allows for lowering the sintering temperature of the technical ceramic materials exemplified above to a range of about 500 °C to 900 °C. This procedure furthermore allows to be beneficially affected by the selection of a ceramic material having a particle size of preferably less than about 1 µm regarding further lowering of the sintering temperature.

Hence, the process according to the invention allows the manufacture of a metal-ceramic substrate in only one single process run, wherein initially the metal-ceramic assembly for the determination of the overall assembly of the metal-ceramic substrate is formed, and subsequently the ceramic body is sintered in the presence of the metal body, and finally the metal body is bonded to the ceramic body. This allows the manufacture process to be significantly more efficient and simple.

Moreover, forming the metal-ceramic assembly is basically not subject to restrictions as to the three dimensional assembly thereof, so that, according to the process of the invention, also the manufacture of multilayer metal-ceramic substrates having buried ceramic bodys or having metallizing structures located in the interior, respectively, is enabled.

One embodiment of the invention that is especially preferred and advantageous in the view of saving process costs provides for the steps of forming the metal-ceramic assembly, sintering the ceramic material into the ceramic body and bonding the metal body to the ceramic body to be performed in one single step. It is to be understood that bonding may also be done separately.

Sintering the ceramic body is performed in the process according to the invention at a sintering pressure in the range of about 1 GPa to 8 GPa, in order to be able to achieve sufficient decrease of the sintering temperature, i.e. especially lowering the sintering temperature below the bonding temperature.

A still further advantageous embodiment of the invention provides for the metal-ceramic assembly to be formed layer-wise, by way of pre-formed ceramic green bodies and/or a powdered ceramic material and by way of pre-formed oxidized sheet metal plates and/or metal oxide powder. In this way the ceramic green bodies may also be formed into a compacted body having a three dimensional design, into which for example the oxidized sheet metal plates will be inserted. The compacted body may also comprise partially sintered ceramic elements.

If the ceramic green bodies or the ceramic compacted body contains a binding agent, the step of forming the metal-ceramic assembly may furthermore comprise expelling the binding agent from the ceramic material at a temperature below the sintering temperature and below the bonding temperature.

If a metal oxide powder is used to form the metal body, Al₂O₃ as a ceramic filler may advantageously be admixed to the metal oxide powder as well, to modify the thermal expansion coefficient of the metal body such that in thermal cycles of the metal-ceramic substrate resulting from the process according to the invention, as they for example may appear during its ordinary use as a interconnect device of power electronic modules, lower mechanical stresses between the ceramic body and the metal body connected thereto occur. This results in increased reliability or life time, respectively, of the produced composite material.

According to another advantageous embodiment of the invention, the metal-ceramic assembly is formed by way of powdered ceramic materials and by way of pre-formed oxidized sheet metal plates, wherein the powdered ceramic material, in this case, will be joggled in around the metal body. In this way, even complicated three dimensional metallizing structures, especially for example multilayered metallizing planes located within the ceramic body are allowed to be realized by predetermining the accordingly formed metal body in the form of oxidized sheet metal plates and by subsequently joggling in the powdered ceramic material around said metal body in a void-free manner.

Another advantageous embodiment of the invention provides for the metal-ceramic assembly to be formed by way of 3D printing by layer-wise printing a powdered ceramic material and a metal oxide powder. In this way, almost arbitrary shaped forms and structures of the metal-ceramic assembly are allowed to be formed. Specifically, 3D printing enables the design of arbitrary complicated metallizing structures even within the ceramic body, so that for example manufacture of multi-layered metal-ceramic substrates having one or more metallizing planes within the ceramic body is allowed. Moreover, sintering by the use of a sintering pressure above the atmospheric air pressure, according to the invention, in combination with 3D printing of the metal-ceramic assembly is especially advantageous, since application of pressure during sintering often results in avoiding or minimizing residual porosity of the resulting ceramic body, respectively.

Due to the free form design of the metal-ceramic assembly enabled by 3D printing, during forming of the metal-ceramic assembly, at least one part of the metal body may be located within the ceramic material, so that this part of the metal body is essentially fully surrounded by the ceramic material. For an external electrical connection of part of the metal body buried in the ceramic body in the above-mentioned manner, which for example may be for forming conductor lines of the metal-ceramic substrate resulting from said process, for example terminal and/or contact areas, which are in contact with the buried metallizing part, may be provided on the edge side and/or the surface side of the metal-ceramic assembly. Preferably, for electrically connecting different metallizing parts on different metallizing planes appropriate metallic through-hole platings are allowed to be formed in the metal-ceramic assembly.

Preferably, bonding of the metal body to the ceramic body, i.e. specifically DCB bonding, is performed at under atmospheric air pressure, and thus is performed without application of additional pressure.

A still further advantageous embodiment of the invention provides for oxygen-donating sacrificing materials, which are reduced at the sintering temperature and emit oxygen, to be added in the sintering step exterior of the metal-ceramic assembly. As a sacrificing material for example oxidized sheet metal plates are suitable, which are reduced at the sintering temperature and will emit oxygen. In this way, reduction of the metal body of the metal-ceramic assembly during sintering can be avoided.

According to a further advantageous embodiment of the invention the metal-ceramic assembly will be hermetically sealed during the sintering step. Thus, atmospheric exchange with the process gas present during sintering of the metal-ceramic assembly will be reduced or will even be suppressed, whereby reduction of the metal body of the metal-ceramic assembly will already be avoided during sintering.

A still further advantageous embodiment of the invention provides for the sintering step to be performed in an oxygen-neutral inert gas atmosphere. As a neutral gas, for example nitrogen (N) or argon (Ar) may be used. Also in this way, it is enabled that reduction of the metal body of the metal-ceramic assembly during sintering is effectively avoided.

Additionally, according to a further advantageous embodiment of the invention, an oxygen portion of 0 to about 3 atomic percent may also be admixed into the inert gas atmosphere to effectively avoid reduction of the metal body of the metal-ceramic assembly during sintering.

The sintering pressure applied during sintering may be generated by mechanical pressing or hot-isostatic pressing under an inert gas atmosphere, for example nitrogen (N) as a an inert gas.

A still further advantageous embodiment of the invention provides for ceramic particles, for example SiC or BN, sintering at a temperature higher than the sintering temperature maximally reached in the sintering step and the bonding temperature maximally reached in the bonding step, and/or pyrolyzing organic components, which pyrolytically decompose in the sintering step or in the binding step, to be arranged at least on part of its outer surfaces and/or at least on a part of the metal body extending within the metal-ceramic assembly.

This allows formation of mechanical buffer or separating layers. These may be arranged at the substrate edge and may in this way facilitate release of the metal-ceramic substrate for example from the sinter mold. They may also be arranged within the ceramic body, especially in the range of metallizations buried in the ceramic body, and may mechanically decouple the critical metal realizations from the ceramic body, to avoid that metallization surrounded by ceramic body on all sides, at temperature cycles, such as they for example may arise during operation of the metal-ceramic substrate resulting from the process according to the invention as interconnect devices of power electronic modules, will damage the ceramic body due to different thermal expansion. Accordingly, it is preferred to firmly connect or bond, respectively, the part of the metal body buried within the ceramic body in thickness direction (z-direction) of the metal-ceramic substrate to the ceramic body and to free it in lateral direction (x-/y direction) from the ceramic body, for example by appropriate internal voids, which may be formed by the use of ceramic particles and/or pyrolyzing components that are non-sintering at the process temperatures employed in the process according to the invention.

If buffer or separating layers are provided at the substrate edge to facilitate mold release of the metal-ceramic substrate, for example from the sintering mold, subsequent grinding or lapping of the surfaces of the metal-ceramic substrate may be of advantage, to remove the porous separating layer from the metal-ceramic substrate without residue.

According to still another advantageous embodiment of the invention, in the step of forming the metal-ceramic assembly, at least a recess of the metal-ceramic assembly at at least one of its outer surfaces may be filled with a water soluble solid substance, which melts at a sintering temperature higher than that maximally reached in the sintering step and/or than the bonding temperature maximally reached in the bonding step, wherein the water soluble substance is dissolved in an aqueous solution following sintering or following bonding, thus releasing the final form of the metal-ceramic substrate. As such a water soluble substance for example NaCI may be used. Specifically, in combination with the use of the 3D printing described herein, formation of arbitrary complicated shapes will be possible.

Alternatively or in addition, formation of the recess at the surface of the metal-ceramic assembly will even be possible by way of an appropriately formed die. It may, for example, be molded to the inside of a sintering mold.

Further characteristics and advantages of the invention result from the following description of working examples of the invention intended to be non-limiting that in the following will be explained in details by referring to the drawings, wherein:
- Fig. 1: schematically shows a cross sectional view through a sintering mold for illustrating a first step of a first working example of a process for the manufacture of a metal-ceramic substrate according to the invention,
- Fig. 2: schematically shows a cross sectional view through the sintering mold for illustrating a second step of the first working example of the process for the manufacture of a metal-ceramic substrate according to the invention,
- Fig. 3: schematically shows a cross sectional view through the sintering mold for illustrating a third step of the first working example of the process for the manufacture of a metal-ceramic substrate according to the invention,
- Fig. 4: schematically shows a cross sectional view through the sintering mold for illustrating a fourth step of the first working example of the process for the manufacture of a metal-ceramic substrate according to the invention,
- Fig. 5: schematically shows a cross sectional view through a metal-ceramic substrate according to a second working example of a process for the manufacture of a metal-ceramic substrate according to the invention,
- Fig. 6: schematically shows a cross sectional view through the metal-ceramic substrate represented in Fig. 5 according to another process step,
- Fig. 7: schematically shows a cross sectional view through a sintering mold for illustrating a step of a third working example of a process for the manufacture of a metal-ceramic substrate according to the invention and
- Fig. 8: schematically shows a cross sectional view through the metal-ceramic substrate produced in Fig. 7.

In the different figures, parts that are equivalent in relation to their function are throughout identified by the same reference numbers, so that they will only be described once.

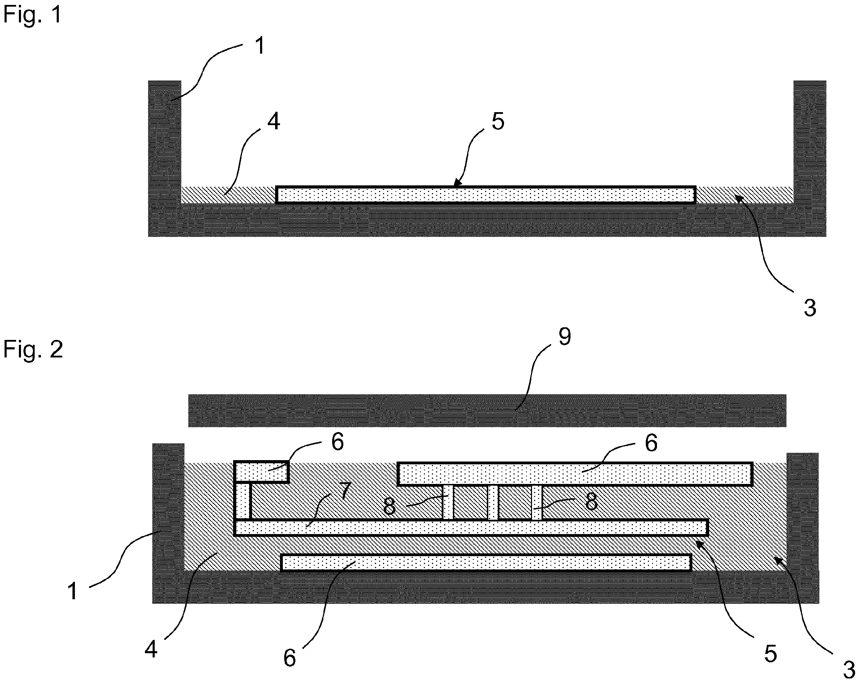

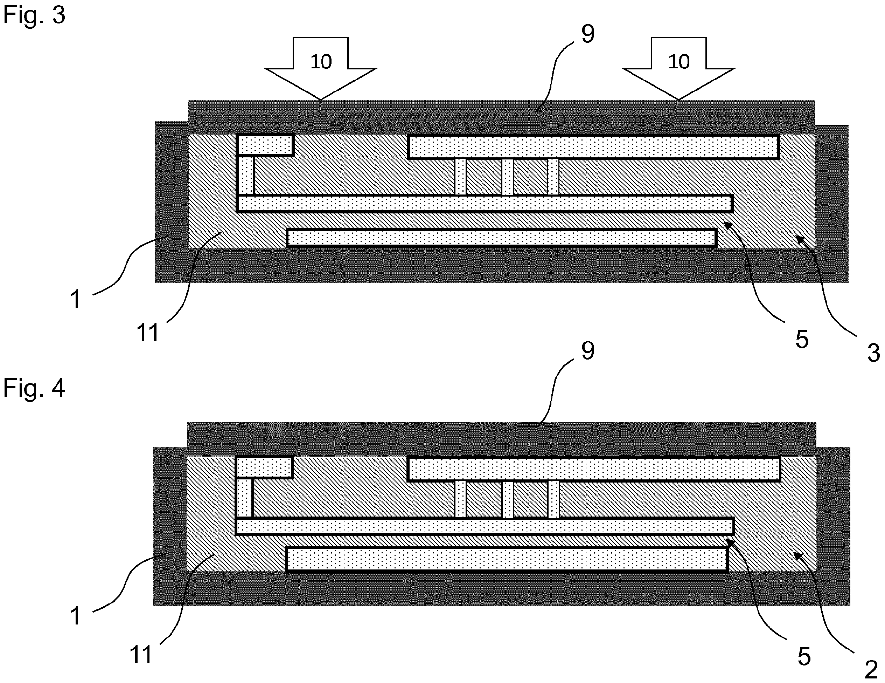

Fig. 1 represents a cross sectional view through a sintering mold 1 for illustrating a first step of a first working example of a process for the manufacture of a metal-ceramic substrate 2 (refer to Fig. 4) according to the invention. In Fig. 1, the first process step of initially forming a metal-ceramic assembly 3 of an at least partially non-sintered ceramic material 4 and at least an oxidized metal body 5 is represented. As can be seen, the metal body 5 is in contact with the ceramic material 4 or is fully surrounded by it at the sides in the exemplary process step herein described, respectively. The ceramic material 4 may be provided both by preformed ceramic green bodies and a ceramic powder. Similarly, the metal body 5 may be provided by preformed, oxidized sheet metal plates, for example oxidized copper sheet plates, or may be provided by a metal oxide powder.

If the non-sintered ceramic material 4 is provided by a ceramic powder and the metal body 5 is provided by preformed, oxidized sheet metal plates, the ceramic powder is preferably joggled in around the metal body 5 arranged in the sintering mold to form the metal-ceramic assembly 3 in the sintering mold.

If both the non-sintered ceramic material 4 and the metal body 5 are provided through a ceramic powder and a metal oxide powder, both the ceramic material 4 and the metal body 5 are preferably layer-wise printed by way of 3D printing into the sintering mold to form the metal-ceramic assembly 3 in the sintering mold.

Fig. 2 represents a cross sectional view through the sintering mold 1 for illustrating a second steps of the first working example of the process for the manufacture the metal-ceramic substrate 2 (refer to Fig. 4) according to the invention. In the process step represented in Fig. 2 the metal-ceramic assembly 3 is fully formed. As can be seen from Fig. 2, the fully formed metal body 5 has both metallizations 6 adjacent to the surfaces of the ceramic material 4 and metallization 7 buried in the interior of the ceramic material 4. As it is exemplified in Fig. 2, the buried metallization 7 is electrically connected to the upper surface metallization 6 via electrically conductive metal through-hole platings 8. Accordingly, in Fig. 2 the manufacture of a multilayer metal-ceramic substrate 2 (refer to Fig. 4) is represented.

A sealing cover 9 of the sintering mold 1 is also represented in Fig. 2. As can be seen, the sealing cover 9 does not (yet) seal the sintering mold 1 in the state represented in Fig. 2.

In Fig. 2 expelling a binding agent contained in the metal-ceramic assembly 3 is represented. The temperature and the holding period for expelling the binding agent may be selected according to the binding agent used. The temperature is for example between 100 °C and 200 °C, for example about 150 °C, and may for example be maintained for a period between about 5 and 15 minutes. Expelling the binding agent from the metal-ceramic assembly 3 is preferably done under atmospheric air pressure, and is done in an unpressurized manner.

Fig. 3 represents a cross sectional view through the sintering mold 1 for illustrating a third step of the first working example of the process for the manufacture of the metal-ceramic substrate 2 (refer to Fig. 4) according to the invention. In Fig. 3 the sintering mold 1 is sealed by way of the sealing cover 9, and is preferably hermetically sealed. Specifically, in the process step represented in Fig. 3, a sintering pressure 10 is applied via the sealing cover 9 by mechanically pressing to the metal-ceramic assembly 3 present in the sintering mold 1, wherein the ceramic material 4 (refer to Fig. 2) of the metal-ceramic assembly 3 is sintered at a sintering temperature below a bonding temperature of the metal body 5 and at a sintering pressure higher than the atmospheric air pressure for a predictable sintering period to form a ceramic body 11 from the ceramic material 4. The sintering temperature is between about 500 °C and 900 °C, for example 800 °C, and the sintering pressure is between about 1 GPa and 8 GPa. The sintering period may for example be about 5 to 20 minutes.

Fig. 4 represents a cross sectional view through the sintering mold 1 for illustrating a fourth step of the first working example of the process for the manufacture the metal-ceramic substrate 2 according to the invention. In the process step represented in Fig. 4 the metal body 5 of the metal-ceramic assembly 3 (refer to Fig. 3) is bonded to the sintered ceramic body 11 at bonding temperature for a predictable bonding period to form the metal-ceramic substrate 2. Bonding is preferably performed under atmospheric air pressure, and is performed in an unpressurized manner, preferably in the same sintering mold, which is also used to sinter the ceramic body 11. The bonding temperature in DCB bonding is between about 1025 °C and 1083 °C, for example 1065 °C.

Following bonding, the metal-ceramic substrate 2 is cooled to room temperature.

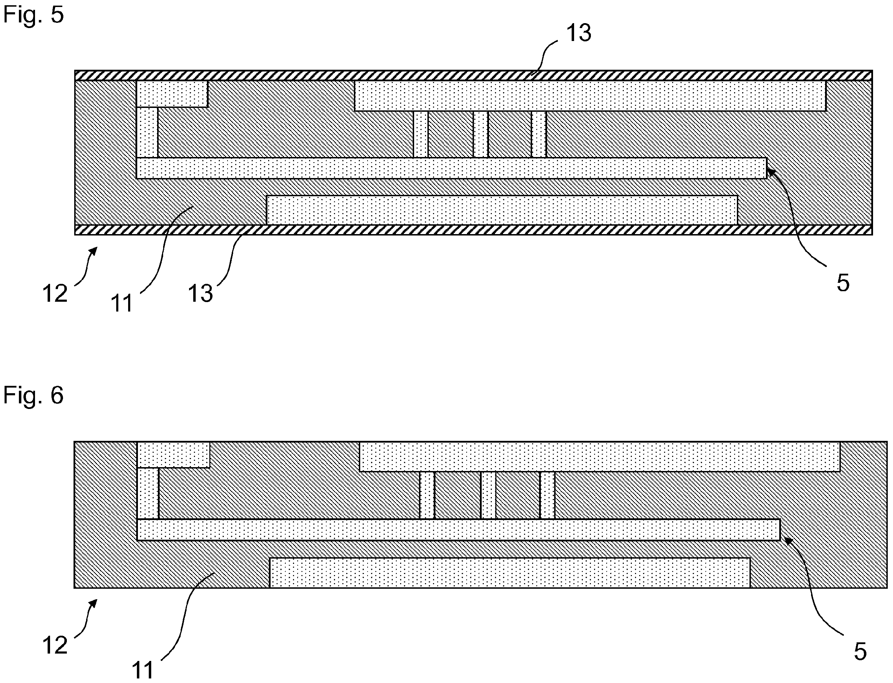

Fig. 5 represents a cross sectional view through a metal-ceramic substrate 12 produced according to a second working example of a process for the manufacture of a metal-ceramic substrate according to the invention. Herein, in the step of forming the metal-ceramic assembly (not represented) ceramic particles were arranged on its outer surfaces (top and bottom side) sintering at a temperature higher than the sintering temperature maximally reached in the sintering step and the bonding temperature maximally reached in the bonding step. In this way, a porous separating layer 13 is formed on the top and bottom side of the metal-ceramic substrate 12, which for example may be removed from the resulting metal-ceramic substrate 12 by way of grinding or lapping, as represented in Fig. 6. The porous separating layers 13, which for example are formed of BN or SiC may substantially facilitate release of the metal-ceramic substrate 12 from the sintering mold (not represented herein).

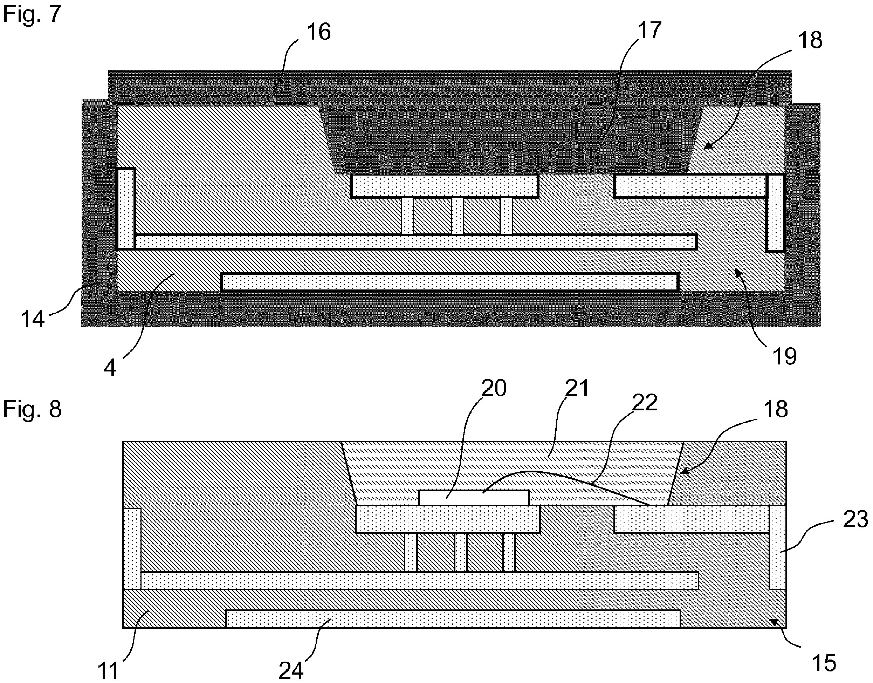

Fig. 7 represents a cross sectional view through a sintering mold 14 for illustrating a step of a third working examples of a process for the manufacture of a metal-ceramic substrate 15 (refer to Fig. 8) according to the invention. As can be seen, a sealing cover 16 or die of the sintering mold 14 comprises a protrusion 17 facing the inner space of the sintering mold 14. In this way, a recess 18 corresponding to the protrusion 17 may be formed or may be kept free in a metal-ceramic assembly 19, respectively.

Fig. 8 represents a cross sectional view through the metal-ceramic substrate 15 produced in Fig. 7, wherein the metal-ceramic substrate 15 has already been fitted with a power electronic component 20. As can be realized from Fig. 8, the component 20 is arranged in the recess 18 , which, in addition, was filled with a glass material or hard casting material 21, following contact of the component 20 with the metal-ceramic substrate 15. As furthermore becomes apparent from Fig. 8, the electronic component 20 is in electrically conductive communication with a metallization 23 laterally exiting the metal-ceramic substrate 15 via an electrically conductive connection 22. A thermal attachment of the metal-ceramic substrate 15 is provided by its bottom side metallization 24.

Thus, the above-described invention may principally be applied to any kind of ceramic substrate, especially for example AIN (aluminum nitride), Si₃N₄ (silicium nitride), Al₂O₃ (aluminum oxide) and the like (technical ceramics), with which a metal body, for example from Cu (copper) or Al (aluminum) or from an alloy thereof may be bonded and the sintering temperature thereof may allowed to be adjusted below the respective bonding temperature for bonding the metal body to the ceramic body by application of pressure above atmospheric air pressure during sintering and/or by application of ceramic material having sufficiently low particle size, for example lower than about 1 µm. Herein, the term "substrate" is used as a synonym for all types of substrates previously mentioned.

In a preferred embodiment, the metal-ceramic substrate produced by the process according to the invention is used for the fabrication of electrical circuits, especially power semiconductor circuits, for power semiconductor modules.

### List of References:

- 1: Sintering mold
- 2: Metal-ceramic substrate
- 3: Metal-ceramic assembly
- 4: Ceramic material
- 5: Metal body
- 6: Surface metallization
- 7: Buried metallization
- 8: Metal through-hole plating
- 9: Sealing cover
- 10: Sintering pressure
- 11: Ceramic body
- 12: Metal-ceramic substrate
- 13: Separating layer
- 14: Sintering mould
- 15: Metal-ceramic substrate
- 16: Sealing cover
- 17: Protrusion
- 18: Recess
- 19: Metal-ceramic assembly
- 20: Power electronic component
- 21: Glas- or hard casting material
- 22: Electrical connection

- 23: Lateral metallization
- 24: Bottom side metallization

## Claims

1. A process for the manufacture of a metal-ceramic substrate (2, 12, 15), comprising at least the following steps:
- initially forming a metal-ceramic assembly (3, 19) of an at least partially non-sintered ceramic material (4) and at least an oxidized metal body (5), which at least partially is in contact with the ceramic material (4);
- subsequently sintering the ceramic material (4) of the metal-ceramic assembly (3, 19) at a sintering temperature below a bonding temperature of the metal body (5) and under a sintering pressure higher than the atmospheric air pressure for a predictable sintering period to form a ceramic body (11) from the ceramic material (4) in the presence of the metal body (5), wherein:
∘ the ceramic material (4) to be sintered is a ceramic material, which, under atmospheric air pressure, sinters at a temperature above the bonding temperature of the metal body (5),
∘ the sintering temperature is between 500 °C and 900 °C, and
∘ the sintering pressure is between 1 GPa to 8 GPa;
- finally, DCB bonding the metal body (5) of the metal-ceramic assembly (3, 19) to the sintered ceramic body (11) at a bonding temperature between 1025 °C and 1083 °C for a predictable bonding period to form the metal-ceramic substrate (2, 12, 15); and
- cooling the metal-ceramic substrate (2, 12, 15) to room temperature.

2. The process according to claim 1, wherein the steps of forming the metal-ceramic assembly (3, 19), sintering the ceramic material (4) into a ceramic body (11) and bonding the metal body (5) to the ceramic body (11) are performed in one single sintering mold (1, 14).

3. The process according to claim 1 or 2, wherein the metal-ceramic assembly (3, 19) is formed layer-wise by way of pre-formed ceramic green bodies and/or of a powdered ceramic material and by way of pre-formed, oxidized sheet metal plates and/or of a metal oxide powder.

4. The process according to claim 1 or 2, wherein the metal-ceramic assembly (3, 19) is formed by way of a powdered ceramic material and by way of pre-formed, oxidized sheet metal plates, wherein the powdered ceramic material is joggled in around the metal body (5).

5. The process according to claim 1 or 2, wherein the metal-ceramic assembly (3, 19) is formed by way of 3D printing, by layer-wise printing a powdered ceramic material and a metal oxide powder.

6. The process according to one of the preceding claims, wherein, in forming the metal-ceramic assembly (3, 19), at least part of the metal body (5) is arranged within the ceramic material (4).

7. The process according to one of the preceding claims, wherein bonding of the metal body (5) to the ceramic body (4) is performed under atmospheric air pressure.

8. The process according to one of the preceding claims, wherein, in the sintering step, oxygen-donating sacrificing materials, which are reduced at the sintering temperature and emit oxygen, are added exteriorly of the metal-ceramic assembly (3, 19).

9. The process according to one of the preceding claims, wherein the metal-ceramic assembly (3, 19) is hermetically sealed in the sintering step.

10. The process according to one of the preceding claims, wherein the sintering step is performed under an oxygen-neutral inert gas atmosphere, wherein the neutral gas is N₂ or Ar.

11. The process according to the preceding claim, wherein an oxygen portion of 0 to 3 atomic percent is admixed to the inert gas atmosphere.

12. The process according to one of the preceding claims, wherein the sintering pressure is created by mechanical pressing or by hot-isostatic pressing under an inert gas atmosphere.

13. The process according to one of the preceding claims, wherein, in the step of forming the metal-ceramic assembly (3, 19), at least at one part of at least one of its outer surfaces and/or at least at one part of the metal body (5) extending in the interior of the metal-ceramic assembly (3, 19) ceramic particles are arranged, sintering at a temperature higher than the sintering temperature maximally reached in the sintering step and higher than the bonding temperature maximally reached in the bonding step, and/or pyrolyzing organic components are arranged, which pyrolytically decompose in the sintering step or in the bonding step.

14. The process according to one of the preceding claims, wherein in the step of forming the metal-ceramic assembly (19) at least a recess (18) of the metal-ceramic assembly (19), at at least one of the surfaces thereof, is filled with a water soluble solid substance, which melts at a temperature higher than the sintering temperature maximally reached in the sintering step and/or higher than the bonding temperature maximally reached in the bonding step, wherein the water soluble substance is dissolved in an aqueous solution following sintering or following bonding.

## Patentansprüche

1. Ein Verfahren zum Herstellen eines Metall-Keramik Substrats (2, 12, 15), aufweisend zumindest die folgenden Schritte:
- zunächst Bilden einer Metall-Keramik Baugruppe (3, 19) aus einem zumindest teilweise nicht-gesinterten Keramikmaterial (4) und zumindest einem oxidierten Metallkörper (5), welcher zumindest teilweise mit dem Keramikmaterial (4) in Kontakt ist;
- nachfolgendes Sintern des Keramikmaterials (4) der Metall-Keramik Baugruppe (3, 19) bei einer Sinter-Temperatur unter einer Bonden-Temperatur des Metallkörpers (5) und bei einem Sinterdruck, welcher höher als der Atmosphärendruck ist, für eine prognostizierbare Sinter-Zeitspanne, um einen Keramikkörper (11) aus dem Keramikmaterial (4) in der Anwesenheit des Metallkörpers (5) zu bilden, wobei:
• das zu sinternde Keramikmaterial (4) ein Keramikmaterial ist, welches bei Atmosphärendruck bei einer Temperatur über der Bonden-Temperatur des Metallkörpers (5) sintert,
• die Sinter-Temperatur zwischen 500 °C und 900 °C ist, und
• der Sinter-Druck zwischen 1 GPa und 8 GPa ist;
- abschließend DCB-Bonden des Metallkörpers (5) der Metall-Keramik Baugruppe (3, 19) an den gesinterten Keramikkörper (11) bei einer Bonden-Temperatur zwischen 1025 °C und 1083 °C für eine prognostizierbare Bonden-Zeitspanne, um das Metall-Keramik Substrat (2, 12, 15) zu bilden; und
- Kühlen des Metall-Keramik Substrats (2, 12, 15) zu Raumtemperatur.

2. Das Verfahren gemäß Anspruch 1, wobei die Schritte des Bildens der Metall-Keramik Baugruppe (3, 19), des Sinterns des Keramikmaterials (4) zu einem Keramikkörper (11) und des Bondens des Metallkörpers (5) an den Keramikkörper (11) in einer einzigen Sinter-Form (1, 14) durchgeführt werden.

3. Das Verfahren gemäß Anspruch 1 oder 2, wobei die Metall-Keramik Baugruppe (3, 19) schichtweise mittels vorgeformter Keramik-Grünkörper und/oder aus einem pulverförmigen Keramikmaterial und mittels vorgeformter, oxidierter Blechplatten und/oder aus einem Metalloxid-Pulver gebildet wird.

4. Das Verfahren gemäß Anspruch 1 oder 2, wobei die Metall-Keramik Baugruppe (3, 19) mittels eines pulverförmigen Keramikmaterials und mittels vorgeformter, oxidierter Blechplatten gebildet wird, wobei das pulverförmige Keramikmaterial um den Metallkörper (5) verzahnt ist.

5. Das Verfahren gemäß Anspruch 1 oder 2, wobei die Metall-Keramik Baugruppe (3, 19) mittels 3D-Druckens, mittels schichtweisen Druckens eines pulverförmigen Keramikmaterials und eines Metalloxid-Pulvers gebildet wird.

6. Das Verfahren gemäß einem der vorangehenden Ansprüche, wobei beim Bilden der Metall-Keramik Baugruppe (3, 19) zumindest ein Teil des Metallkörpers (5) in dem Keramikmaterial (4) angeordnet ist.

7. Das Verfahren gemäß einem der vorangehenden Ansprüche, wobei das Bonden des Metallkörpers (5) an den Keramikkörper (4) unter Atmosphärendruck durchgeführt wird.

8. Das Verfahren gemäß einem der vorangehenden Ansprüche, wobei bei dem Sintern-Schritt Sauerstoff abgebende Opfermaterialien, welche bei der Sinter-Temperatur reduziert werden und Sauerstoff emittieren, äußerlich der Metall-Keramik Baugruppe (3, 19) hinzugefügt werden.

9. Das Verfahren gemäß einem der vorangehenden Ansprüche, wobei die Metall-Keramik Baugruppe (3, 19) in dem Sintern-Schritt hermetisch abgedichtet wird.

10. Das Verfahren gemäß einem der vorangehenden Ansprüche, wobei der Sintern-Schritt bei einer sauerstoffneutralen Inertgasatmosphäre durchgeführt wird, wobei das neutrale Gas N₂ oder Ar ist.

11. Das Verfahren gemäß dem vorangehenden Anspruch, wobei ein Sauerstoffanteil von 0 bis 3 Atomprozent der Inertgasatmosphäre beigemischt ist.

12. Das Verfahren gemäß einem der vorangehenden Ansprüche, wobei der Sinter-Druck mittels mechanischen Pressens oder mittels heißisostatischen Pressens bei einer Inertgasatmosphäre erzeugt wird.

13. Das Verfahren gemäß einem der vorangehenden Ansprüche, wobei bei dem Schritt des Bildens der Metall-Keramik Baugruppe (3, 19) zumindest an einem Teil von zumindest einer ihrer äußeren Oberflächen und/oder zumindest an einem Teil des Metallkörpers (5), welcher sich in das Innere der Metall-Keramik Baugruppe (3, 19) erstreckt, Keramikpartikel angeordnet sind, wobei das Sintern bei einer Temperatur durchgeführt wird, welche höher als die Sinter-Temperatur ist, welche maximal in dem Sintern-Schritt erreicht wird und höher als die Bonden-Temperatur ist, welche maximal in dem Bonden-Schritt erreicht wird, und/oder pyrolysierende organische Verbindungen angeordnet sind, welche sich bei dem Sintern-Schritt oder bei dem Bonden-Schritt pyrolytisch abbauen.

14. Das Verfahren gemäß einem der vorangehenden Ansprüche, wobei bei dem Schritt des Bildens der Metall-Keramik Baugruppe (19) zumindest eine Aussparung (18) der Metall-Keramikbaugruppe (19) an zumindest einer Oberfläche davon mit einer wasserlöslichen, festen Substanz gefüllt ist, welche bei einer Temperatur schmilzt, welche höher als die Sinter-Temperatur ist, welche maximal in dem Sintern-Schritt erreicht wird, und/oder höher als die Bonden-Temperatur ist, welche maximal in dem Bonden-Schritt erreicht wird, wobei die wasserlösliche Substanz in einer wässrigen Lösung gelöst wird, nach dem Sintern oder nach dem Bonden.

## Revendications

1. Un procédé de fabrication d'un substrat métal-céramique (2, 12, 15), comprenant au moins les étapes suivantes :
- le fait de former initialement un ensemble métal-céramique (3, 19) d'un matériau céramique (4) au moins partiellement non fritté et d'au moins un corps métallique oxydé (5), qui est au moins partiellement en contact avec le matériau céramique (4) ;
- le fait de fritter subséquemment le matériau céramique (4) de l'ensemble métal-céramique (3, 19) à une température de frittage inférieure à une température de liaison du corps métallique (5) et sous une pression de frittage supérieure à la pression atmosphérique pour une période de frittage prévisible pour former un corps céramique (11) à partir du matériau céramique (4) en présence du corps métallique (5) ;
∘ le matériau céramique (4) à fritter est un matériau céramique qui, sous la pression atmosphérique, fritte à une température supérieure à la température de liaison du corps métallique (5),
∘ la température de frittage est comprise entre 500 °C et 900 °C, et
∘ la pression de frittage est comprise entre 1 GPa et 8 GPa ;
- enfin, le fait de lier par DCB le corps métallique (5) de l'ensemble métal-céramique (3, 19) au corps céramique fritté (11) à une température de liaison comprise entre 1025 °C et 1083 °C pendant une durée de liaison prévisible pour former le substrat métal-céramique (2, 12, 15) ; et
- le fait de refroidir le substrat métal-céramique (2, 12, 15) à température ambiante.

2. Le procédé selon la revendication 1, dans lequel les étapes de formation de l'ensemble métal-céramique (3, 19), de frittage du matériau céramique (4) en un corps céramique (11) et de liaison du corps métallique (5) au corps céramique (11) sont réalisés dans un moule de frittage (1, 14) unique.

3. Le procédé selon la revendication 1 ou la revendication 2, dans lequel l'ensemble métal-céramique (3, 19) est formé par couches au moyen de corps crus céramiques préformés et / ou d'un matériau céramique en poudre et au moyen de plaques de tôle préformées oxydées et / ou d'une poudre d'oxyde métallique.

4. Le procédé selon la revendication 1 ou la revendication 2, dans lequel l'ensemble métal-céramique (3, 19) est formé au moyen d'un matériau céramique en poudre et au moyen de plaques de tôle préformées oxydées, le matériau céramique en poudre étant secoué autour du corps métallique (5).

5. Le procédé selon la revendication 1 ou la revendication 2, dans lequel l'ensemble métal-céramique (3, 19) est formé par impression 3D, par impression par couches d'un matériau céramique en poudre et d'une poudre d'oxyde métallique.

6. Le procédé selon l'une des revendications précédentes, dans lequel, lors de la formation de l'ensemble métal-céramique (3, 19), au moins une partie du corps métallique (5) est disposée à l'intérieur du matériau céramique (4).

7. Le procédé selon l'une des revendications précédentes, dans lequel la liaison du corps métallique (5) au corps céramique (4) est réalisée sous pression atmosphérique.

8. Le procédé selon l'une des revendications précédentes, dans lequel, lors de l'étape de frittage, des matériaux sacrificiels donneurs d'oxygène, qui sont réduits à la température de frittage et émettent de l'oxygène, sont ajoutés extérieurement à l'ensemble métal-céramique (3, 19).

9. Le procédé selon l'une des revendications précédentes, dans lequel l'ensemble métal-céramique (3, 19) est hermétiquement scellé lors de l'étape de frittage.

10. Le procédé selon l'une des revendications précédentes, dans lequel l'étape de frittage est réalisée sous une atmosphère de gaz inerte neutre en oxygène, le gaz neutre étant du N₂ ou de l'Ar.

11. Le procédé selon la revendication précédente, dans lequel une portion d'oxygène de 0 à 3 pour cent atomique est mélangée à l'atmosphère de gaz inerte.

12. Le procédé selon l'une des revendications précédentes, dans lequel la pression de frittage est créée par pressage mécanique ou par pressage isostatique à chaud sous une atmosphère de gaz inerte.

13. Le procédé selon l'une des revendications précédentes, dans lequel, dans l'étape de formation de l'ensemble métal-céramique (3, 19), des particules de céramique sont disposées au niveau d'au moins une partie d'au moins une de ses surfaces extérieures et / ou au moins au niveau d'une partie du corps métallique (5) s'étendant à l'intérieur de l'ensemble métal-céramique (3, 19), qui se frittent à une température supérieure à la température de frittage atteinte au maximum lors de l'étape de frittage et supérieure à la température de liaison atteinte au maximum lors de l'étape de liaison, et /ou des composants organiques de pyrolyse sont disposés, qui se décomposent par pyrolyse lors de l'étape de frittage ou lors de l'étape de liaison.

14. Le procédé selon l'une des revendications précédentes, dans lequel, dans l'étape de formation de l'ensemble métal-céramique (19), au moins un évidement (18) de l'ensemble métal-céramique (19), au niveau d'au moins une des surfaces de celui-ci, est rempli d'une substance solide soluble dans l'eau, qui fond à une température supérieure à la température de frittage atteinte au maximum lors de l'étape de frittage et / ou supérieure à la température de liaison atteinte au maximum lors de l'étape de liaison, la substance soluble dans l'eau étant dissoute dans une solution aqueuse à la suite du frittage ou à la suite de la liaison.
